# EUROPÄISCHE PATENTSCHRIFT

(11) **EP 1 023 139 B1**
(45) Veröffentlichungstag und Bekanntmachung des Hinweises auf die Patenterteilung: **14.01.2004**
(21) Anmeldenummer: 98961003.5
(22) Anmeldetag: 07.10.1998
(51) Int. Cl.: B23K 20/10, H01L 21/607

(54) **VERFAHREN ZUR QUALITÄTSKONTROLLE**
QUALITY CONTROL METHOD
PROCEDE DE CONTROLE DE LA QUALITE

(30) Priorität: 13.10.1997 DE 19745131
(43) Veröffentlichungstag der Anmeldung: 02.08.2000
(73) Patentinhaber: Hesse & Knipps GmbH, 33100 Paderborn (DE)
(72) Erfinder: HESSE, Hans, Jürgen, D-33106 Paderborn (DE); HOLTGREWE, Dietmar, D-33106 Paderborn (DE)
(74) Vertreter: COHAUSZ DAWIDOWICZ HANNIG & PARTNER
(86) Internationale Anmeldenummer: PCT/DE1998/002999
(87) Internationale Veröffentlichungsnummer: WO 1999/019107

(56) Entgegenhaltungen:
- EP-A- 0 208 310
- EP-A- 0 368 533
- EP-A- 0 540 189
- DD-A- 217 454
- DE-A- 3 333 601

## Beschreibung

Die Erfindung betrifft ein Verfahren gemäß dem Oberbegriff des Anspruchs 1 oder 7 Ein solches Verfahren ist aus EP-A-368533 bekannt.

Für die Montage einer Vielzahl von Halbleiterbauelementen ist es erforderlich, Drahtbrücken zwischen den Kontaktinseln (Bondpads) auf den Halbleiterchips und Kontaktstellen auf Außenanschlüssen herzustellen. Sollen Drahtbrücken mit Aluminiumdraht hergestellt werden, wird zum Bonden das allgemein bekannte Ultraschalldrahtbonden bevorzugt.

Da bei modernen Halbleiterbauelementen oft eine Vielzahl von Bonds zu realisieren ist, wird das Ultraschall-Drahtbonden bevorzugt mit automatisch arbeitenden Ultraschall-Drahtbondern durchgeführt. Es versteht sich, daß hier der Produktivität ein besonderer Stellenwert zugemessen wird. Das bedeutet, daß einerseits die Drahtbrücken in möglichst kurzer Zeit hergestellt werden müssen und andererseits gleichzeitig gewährleistet werden muß, daß die Bondungen ordnungsgemäß ausgeführt werden. Die Bondverbindungen zwischen dem Bonddraht und der jeweiligen Kontaktstelle müssen eine ausreichende Haftkraft aufweisen, d.h., die Schweißpartner müssen bei ausreichend großer Kontaktfläche eine metallische Bindung eingegangen sein.

Um dies zu gewährleisten, ist es notwendig, eine Reihe von Parametern zu berücksichtigen. Solche Parameter sind die Bondkraft, die Ultraschallenergie oder auch der Pegel der Ultraschallschwingungen und die Zeitdauer der Einwirkung der Ultraschallschwingungen. Diese Parameter können über eine geeignete Steuervorrichtung vorgegeben werden. Weitere Parameter, die den Schweißvorgang unmittelbar beeinflussen, sind die Werkstoffparameter, die sich auf die miteinander zu verschweißenden Schweißpartner (Bonddraht, Kontaktstelle) beziehen.

Bei den bisher bekannt gewordenen Verfahren zur Qualitätskontrolle hat sich gezeigt, daß einzelne Parameter als wesentlich erkannt worden sind, die dann während des Ultraschallschweißvorganges gezielt überwacht wurden.

Einer dieser Parameter ist die Verformung des Bonddrahtes während des Ultraschallschweißvorganges. So ist aus der EP 0 208 310 A1 ein Verfahren mit entsprechender Vorrichtung zum Regeln des Prozeßablaufes und zur Qualitätskontrolle beim Ultraschallschweißen von Werkstücken bekannt geworden, bei dem die Verformung der zu verschweißenden Werkstücke zur Steuerung der Prozeßvariablen herangezogen wird. Dazu ist ein Wegaufnehmer in Form einer Lasermeßeinrichtung zur Messung der Lage der Ultraschallsonotrode (Bondkeil) vorgesehen. Das Abschalten des Ultraschallgenerators erfolgt hier bei Erreichen einer vorgegebenen Drahtverformung.

Eine ähnliche Lösung ist auch aus der EP 0 540 189 B1 bekannt geworden. Hier erfolgt die Qualitätskontrolle dadurch, daß die Verformung des Drahtes überwacht wird und neben der Zeitdauer der Ultraschalleinwirkung auch der Pegel gesteuert wird, wobei hier der Pegel mit zunehmender Verformung verringert werden soll.

Auch aus der DE 33 33 601 A1 ist eine Drahtanschluß- bzw. Verdrahtungsvorrichtung mit einem Ultraschallschwinger bekannt geworden, bei der die Verformung des Drahtes mittels eines Spaltfühlers überwacht wird. Die Amplitude und die Zeitdauer der Ultraschalleinwirkung wird hier in Abhängigkeit von der Verformung des Drahtes gesteuert. Zusätzlich ist hier eine Aufsetzkontrolle vorgesehen, bei der die Impedanzänderung im Aufsetzzeitpunkt kontrolliert wird.

Weiterhin ist aus der DD 217 454 A1 ein Verfahren zur Steuerung von Ultraschall-Schweißvorgängen bekannt geworden, bei dem zur Qualitätskontrolle eine ständige Impedanzmessung auch während der anschließenden Ultraschalleinwirkung auf den Draht erfolgt, so daß der Aufsetzzeitpunkt ermittelt werden kann. Da sich die Impedanz während des Ultraschallbondens weiter verändert, können die gemessenen Werte ständig mit Sollwerten verglichen werden. Sobald der für den Abschaltzeitpunkt repräsentative Sollwert erreicht ist, wird der Ultraschallgenerator abgeschaltet.

Es hat sich jedoch gezeigt, daß die Qualitätskontrolle mit derartigen Verfahren oder Vorrichtungen nicht ausreicht und mit Mängeln behaftet ist. So ist die Überwachung des Verformungsverlaufes des Drahtes nicht ausreichend, da dann keineswegs sicher ist, daß beim Abschalten der Ultraschallschwingungen bei Erreichen einer vorgegebenen Verformung auch tatsächlich eine Schweißverbindung mit den gewünschten Eigenschaften hergestellt worden ist. Wird beispielsweise der Bondvorgang mit zuviel Energie gestartet, so erfolgt zwar eine schnelle Verformung, aber es ist ggf. keine metallische Verbindung zwischen den Schweißpartnern entstanden, obwohl der Wert der maximalen Verformung erreicht wurde. Ähnliche Probleme treten auch dann auf, wenn die Amplitude/Leistung der Ultraschallschwingungen während des Schweißvorganges verändert wird. Eine spontane starke Verformung des Drahtes muß also verhindert werden.

Der Erfindung liegt daher die Aufgabe zugrunde, ein Verfahren zur Qualitätskontrolle zu schaffen, welches die aufgezeigten Mängel des Standes der Technik nicht aufweist und mit dem tatsächlich eine gleichbleibende Bondqualität erreicht wird, auch wenn die miteinander zu verschweißenden Schweißpartner bei den einzelnen Schweißvorgängen stark unterschiedliche Parameter, wie z.B. unterschiedlich starke Oxydschichten, Kontaminationen o.ä., aufweisen.

Die der Erfindung zugrundeliegende Aufgabenstellung wird durch ein Verfahren entsprechend der unabhängigen Ansprüche 1 oder 7 gelöst.

Vorteilhafte Ausgestaltungen gehen aus den Unteransprüchen hervor.

Die ausschließliche Berücksichtigung der aktuellen Verformung des Drahtes zur Einstellung der Ultraschall-Leistung reicht also nicht zur Sicherstellung konstanter Bondergebnisse aus. Durch das erfindungsgemäße Verfahren wird sichergestellt, daß eine spontane, nur wenige ms dauernde Verformung des Drahtes während des Bondens nicht stattfindet.

Es wurde herausgefunden, daß die Bondqualität von der Verformungsgeschwindigkeit, also dem Verformungsgradienten, und nicht von der Verformung allein abhängt. Die ausschließliche Berücksichtigung der aktuellen Verformung zur Einstellung der Ultraschall-Leistung reicht also nicht zur Sicherstellung konstanter Bondergebnisse aus.

Um eine spontane Verformung des Drahtes während des Bondens zu verhindern, wird gemäß dem erfindungsgemäßen Verfahren nicht die Verformung des Drahtes sondern die Verformung des Drahtes pro Zeiteinheit (Verformungsgradient mit typ. Werten Δ von einigen 0,5 µm/ms) zur Bestimmung der aktuell benötigten Ultraschall-Leistung herangezogen. Als weiteres Kriterium für die Bestimmung der aktuell benötigten Ultraschall-Leistung bzw. der Bondkraft wird der Grad der Anbindung des Drahtes an die Bondinsel bzw. Kontaktfläche herangezogen. Der Grad der Anbindung wird durch die im Ultraschall-Generator gemessene Impedanz (Betrag und Phase) der Transducer-Bondkeil-Einheit bestimmt. Die auszugebende Ultraschall-Leistung ist in keinem Fall eine Funktion der Zeit, sondern immer eine Funktion des Verformungsgradienten, der aktuellen Impedanz der Transducer-Bondkeil-Einheit sowie der aktuell erreichten Verformung.

Die Erfindung soll nachfolgend an Ausführungsbeispielen näher erläutert werden. In den zugehörigen Zeichnungen zeigen:
- Fig. 1:: ein schematisches Blockschaltbild für das Verfahren zur Qualitätskontrolle, bei dem die erfindungsgemäße Steuerung der Transducer-Bondkeil-Einheit mit Hilfe eines Kennlinienfeldes und eines Reglers zur Korrekturwertbildung erfolgt;
- Fig. 2:: ein Kennlinienfeld der Ultraschall-Leistung in Abhängigkeit vom Gradienten der Drahtverformung und der Impedanzänderung der Transducer-Bondkeil-Einheit; und
- Fig. 3:: ein schematisches Blockschaltbild für ein Verfahren zur Qualitätskontrolle, bei dem die benötigten Bondparameter automatisch erstellt werden.

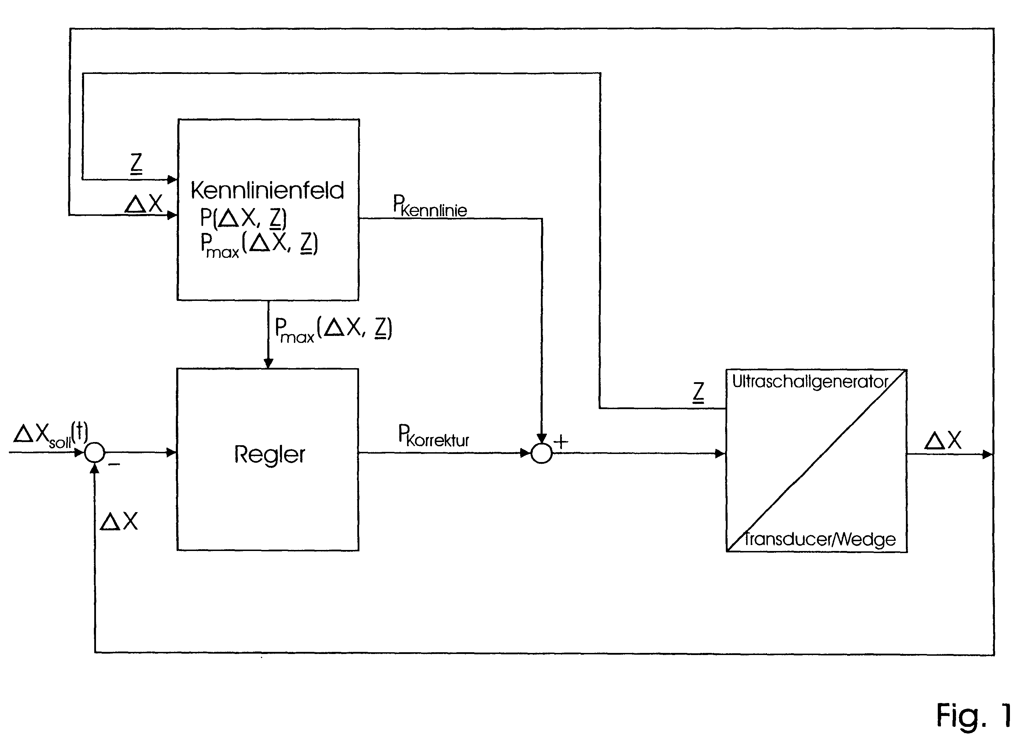

Fig. 1 zeigt eine schematische Darstellung zur Qualitätskontrolle, bei der zur Bestimmung der für den aktuellen Prozeßzustand benötigten Ultraschall-Leistung P eine Tabelle herangezogen wird, in der die zum jeweiligen Prozeßzustand gehörenden Ultraschall-Leistungen P in Abhängigkeit von der Verformung des Drahtes und des Gradienten der Drahtverformung Δx enthalten sind (Methode 1). Diese Tabelle wird von erfahrenen Technologen angelegt und kann stets an neue Erkenntnisse angepaßt werden. Einem dazu parallel liegenden Regler wird der gewünschte Verlauf der Verformung des Drahtes (unterschiedliche Gradienten für die jeweiligen Betriebszustände z.B. "Aufbrechen der Oxidschicht", "Verformen", "Heilen") als Sollwert vorgegeben.

Der den aktuellen Prozeßstand repräsentierende Tabellenwert P_{Kennlinie} wird gemeinsam mit dem Korrekturwert P_{Korrektur} zur Ansteuerung des Ultraschallgenerators bereitgestellt.

Wenn die Abbildung des Prozesses durch die Tabelle hinreichend gut ist, wird der Regler nur sehr kleine Korrekturwerte P_{Korrektur} zu den Tabellenwerten P_{Kennlinie} hinzugeben. Bei großen Abweichungen von dem vorgegebenen Verformungsprofil darf allerdings die Korrekturgröße P_{Korrektur} einen maximalen Wert nicht überschreiten, um eine irreversible, spontane Verformung des Drahtes auszuschließen. Die Werte für die Stellgrößenbeschränkung Pₘₐₓ(Δx, Z) beruhen ebenfalls auf der Erfahrung von Technologen. Aus dem Verlauf des Korrekturwertes für die Stellgröße kann ein Gewichtungsfaktor für die Tabellenwerte abgeleitet werden, durch den eine Adaption der Tabellenwerte an die aktuellen, werkstoffabhängigen Prozeßparameter erreicht wird. Bild 2 zeigt eine derartige Tabelle zur Steuerung des Bondprozesses. Ausgangsgrößen zwischen den Stützstellen werden interpoliert.

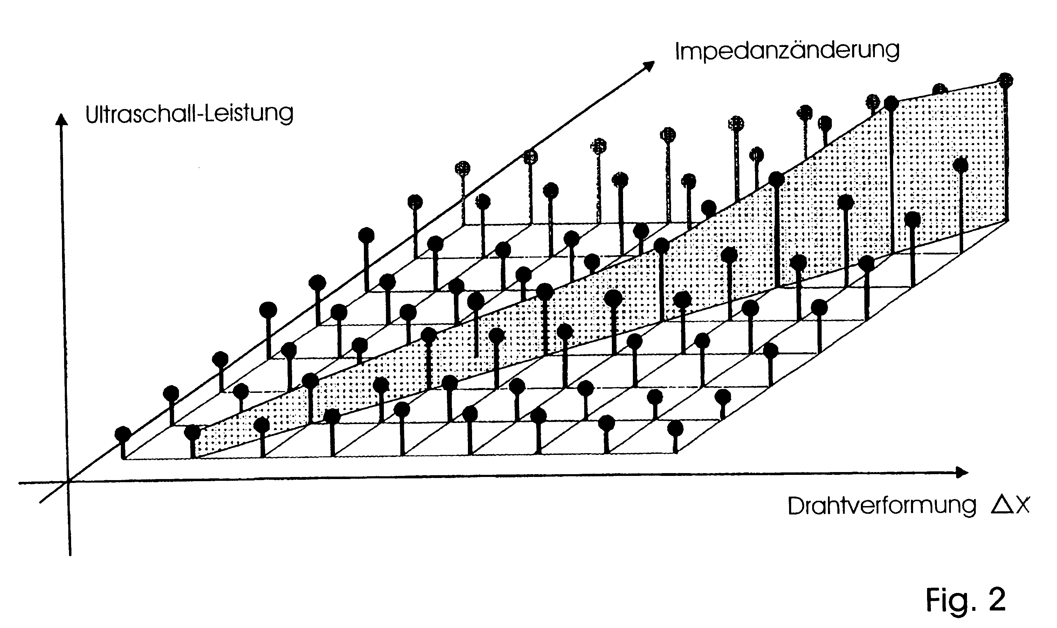

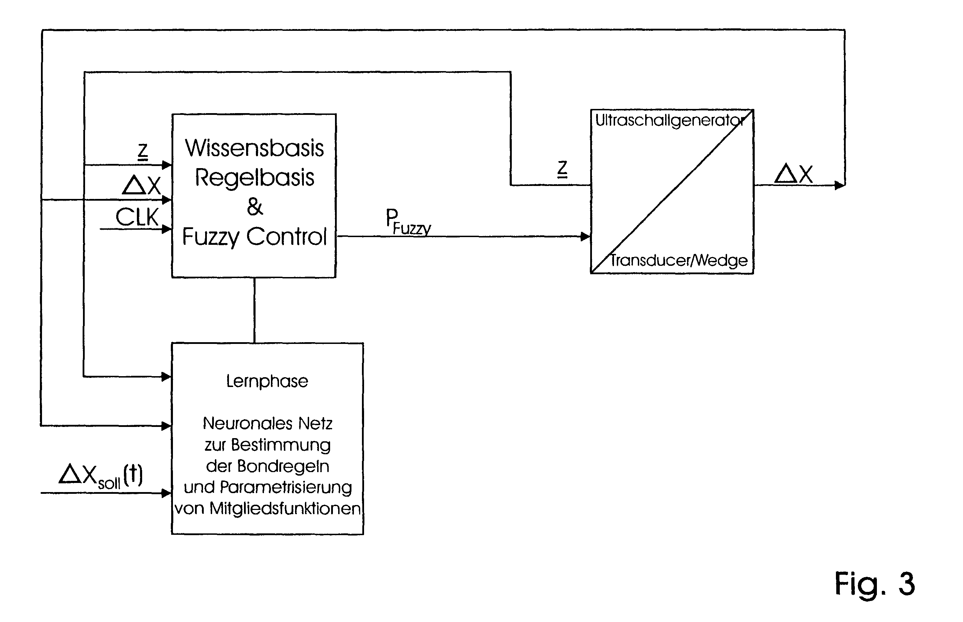

Für Ultraschall-Drahtbondvorrichtungen, auf denen extrem unterschiedliche Materialien gebondet werden, ist die Breite des mit der o.g. Methode erreichbaren Prozeßfensters ggf. zu klein. Dieses Problem wird mit der in Fig. 2, 3 schematisch dargestellten Methode gelöst (Methode 2). Der Operator wird hier zur Bestimmung der optimalen Bondparameter nicht benötigt. Während der Lernphase muß dem Bonder lediglich von außen die den einzelnen Bonds zugeschriebene Qualität mitgeteilt werden.

Dem automatischen Bonden ist (im Gegensatz zu der Methode 1) eine Lernphase vorgeschaltet. Ein neuronales Netz parametrisiert die Mitgliedsfunktionen eines Regelwerks, auf dessen Basis die an die aktuellen Werkstoffdaten angepaßten Bondungen durchgeführt werden. In einer ersten Variante dieser Methode (Methode 2a) wird anhand der nicht scharf formulierten, in der Lernphase prametrisierten Regeln mit Hilfe eines Fuzzy-Reglers die Ultraschall-Leistung P_{Fuzzy} als Funktion der Impedanz Z und der Drahtverformung Δx errechnet, um den vorgegebenen Verformungsverlauf zu erreichen. Dieses Verfahren ist tolerant gegen Schwankungen der Werkstoffdaten und anderer den Prozeß beeinflussenden Umweltbedingungen.

Es ist bekannt, daß bei stabilen Werkstoffdaten und einem geeigneten Prozeßfenster der Bondprozeß bei einer zeitlich fest vorgegebenen Folge von Ultraschall-Pegeln konstant gute Bondergebnisse liefert. Aus diesem Grund kann in einer zweiten Variante zu der o.g. Methode 2 die Berechnung der Stellgrößen entfallen (Methode 2b). Mit einem fest vorgegebenen Takt CLK werden hier die durch das neuronale Netz bestimmten Ultraschall-Pegel P_{Fuzzy} auf die Transducer-Bondkeil-Einheit geschaltet.

### Bezugszeichenliste

- P: Ultraschall-Leistung
- P_{Kennlinie}: Tabellenwert für die Ultraschallleistung
- P_{Korrektur}: Korrekturwert für die Ultraschall-Leistung
- Pₘₐₓ: Maximalleistung
- P_{Fuzzy}: berechnete Ultraschall-Leistung
- Δx: Gradient der Drahtverformung
- x: Absolutwert der Drahtverformung
- Z: Impedanz
- CLK: Taktsignal

## Patentansprüche

1. Verfahren zur Qualitätskontrolle beim Ultraschall-Drahtbonden, bei dem die Verformung eines auf einer Kontaktfläche zu bondenden Drahtes ständig überwacht wird und eine Transducer-Bondkeil-Einheit und ein Ultraschall-Generator gebraucht werden, **dadurch gekennzeichnet, daß** zunächst eine den jeweils aktuellen Prozeßstand repräsentierende Tabelle der Ultraschall-Leistung als Funktion des Gradienten der Verformung des Drahtes, der Impedanz der Transducer-Bondkeil-Einheit sowie der aktuell erreichten Verformung des Drahtes erstellt und in einem Speicher abgelegt wird, daß einem Regler ein gewünschter Gradient der Verformung des Drahtes in Abhängigkeit vom jeweils aktuellen Prozeßstand als Sollwert vorgegeben wird, und daß die Stellgröße für den Ultraschall-Generator durch Addition von im Regler gebildeten Korrekturwerten zu den jeweils aktuellen Tabellenwerten berechnet wird.

2. Verfahren nach Anspruch 1, **dadurch gekennzeichnet, daß** ein Maximalwert für den Korrekturwert vorgegeben wird.

3. Verfahren nach Anspruch 1, **dadurch gekennzeichnet, daß** die Tabelle der Ultraschall-Leistung in Abhängigkeit von der Impedanzänderung der Transducer-Bondkeil-Einheit erstellt wird.

4. Verfahren nach einem der Ansprüche 1 bis 3, **dadurch gekennzeichnet, daß** aus dem Verlauf des Korrekturwertes für die Stellgröße für die Ultraschall-Leistung ein Gewichtungsfaktor für die Tabellenwerte zu deren Adaption an die aktuellen werkstoffabhängigen Prozeßparameter abgeleitet wird.

5. Verfahren nach einem der Ansprüche 1 bis 4, **dadurch gekennzeichnet, daß** die Tabelle der Ultraschall-Leistung in einer Lernphase selbsttätig erstellt wird, wobei zusätzlich lediglich die den einzelnen Bonds zugeschrieben Qualitätsparameter manuell vorgegeben werden.

6. Verfahren nach Anspruch 5, **dadurch gekennzeichnet, daß** mit den in der Lernphase mit Hilfe eines neuronalen Netzes parametrisierten Regeln mit Hilfe eines Fuzzy-Reglers die Ultraschall-Leistung als Funktion der Impedanz und des Gradienten der Verformung des Drahtes errechnet wird.

7. Verfahren zur Qualitätskontrolle beim Ultraschall-Drahtbonden, bei dem die Verformung eines auf einer Kontaktfläche zu bondenden Drahtes ständig überwacht wird und eine Transducer-Bondkeil-Einheit und ein Ultraschall-Generator gebraucht werden, **dadurch gekennzeichnet, daß** in einer Lernphase eine den jeweils aktuellen Prozeßzustand repräsentierende Tabelle der Ultraschall-Leistung als Funktion des Gradienten der Verformung des Drahtes, der Impedanz der Transducer-Bondkeil-Einheit sowie der aktuell erreichten Verformung des Drahtes mit Hilfe der durch ein neuronales Netz parametrisierten Regeln erstellt wird, wobei die für den jeweils aktuellen Prozeßzustand benötigte Ultraschall-Leistung mit Hilfe eines Fuzzy-Reglers errechnet wird und daß durch das neuronale Netz bestimmte Ultraschallpegel mit einem fest vorgegebenen Takt auf den Ultraschall-Generator geschaltet werden.

## Claims

1. Method of quality control during ultrasonic wire bonding, in which the deformation of a wire to be bonded on to a contact surface is constantly monitored and a transducer/bonding wedge unit and an ultrasonic generator are used, **characterized in that** first of all a table, representing the particular current status of the process and relating to the ultrasonic power as a function of the gradient of deformation of the wire, the impedance of the transducer/bonding wedge unit and the deformation of the wire currently achieved, is drawn up and is stored in a memory, **in that** a desired gradient of the deformation of the wire, as a function of the particular current status of the process, is supplied to a controller as nominal value, and **in that** the correcting variable for the ultrasonic generator is calculated by the addition of correction values formed in the controller to the relevant current table values.

2. Method according to Claim 1, **characterized in that** a maximum value is predetermined for the correction value.

3. Method according to Claim 1, **characterized in that** the ultrasonic power table is drawn up as a function of the variation in impedance of the transducer/bonding wedge unit.

4. Method according to one of Claims 1 to 3, **characterized in that** a weighting factor for the table values for their adaptation to the current material-dependent process parameters is derived from the behaviour of the correction value for the correcting variable in respect of the ultrasonic power.

5. Method according to one of Claims 1 to 4, **characterized in that** the ultrasonic power table is automatically drawn up in a learning phase, in which in addition only the quality parameters assigned to the individual bonds are manually preset.

6. Method according to Claim 5, **characterized in that** with the rules parameterized in the learning phase by means of a neural network, the ultrasonic power as a function of the impedance and of the gradient of deformation of the wire is calculated by means of a fuzzy controller.

7. Method of quality control during ultrasonic wire bonding, in which the deformation of a wire to be bonded on to a contact surface is constantly monitored and a transducer/bonding wedge unit and an ultrasonic generator are used, **characterized in that**, in a learning phase, a table, representing the particular current status of the process and relating to the ultrasonic power as a function of the gradient of deformation of the wire, the impedance of the transducer/bonding wedge unit and the currently achieved deformation of the wire, is drawn up using the rules parameterized by a neural network, the ultrasonic power needed for the particular current status of the process being calculated by means of a fuzzy controller, and **in that** ultrasonic levels determined by the neural network and having a fixed predetermined clock pulse are switched to the ultrasonic generator.

## Revendications

1. Procédé pour le contrôle de qualité lors de la liaison ultrasonique de fils métalliques, dans lequel la déformation d'un fil métallique à lier sur une surface de contact est surveillée en permanence et une unité de coin de liaison à transducteur et un générateur ultrasonique sont utilisés,
**caractérisé en ce que**, initialement, une table de la puissance ultrasonique représentant respectivement l'état actuel du processus est établie en tant que fonction du gradient de la déformation du fil métallique, de l'impédance de l'unité de coin de liaison à transducteur ainsi que de la déformation du fil métallique actuellement atteinte et est classée dans une mémoire, qu'un gradient souhaité de la déformation du fil métallique en dépendance respectivement de l'état actuel du processus est prédéfini à un régulateur en tant que valeur de consigne et que la variable réglante pour le générateur ultrasonique est calculée par addition de valeurs de correction formées dans le régulateur respectivement aux valeurs actuelles de la table.

2. Procédé selon la revendication 1,
**caractérisé en ce qu'**une valeur maximale est prédéfinie pour la valeur de correction.

3. Procédé selon la revendication 1,
**caractérisé en ce que** la table de la puissance ultrasonique est établie en dépendance de la modification d'impédance de l'unité de coin de liaison à transducteur.

4. Procédé selon l'une des revendications 1 à 3,
**caractérisé en ce qu'**un facteur de pondération pour les valeurs de la table est dérivé de la variation dans le temps de la valeur de correction pour la variable réglante pour la puissance ultrasonique pour leur adaptation aux paramètres actuels du processus dépendant du matériau.

5. Procédé selon l'une des revendications 1 à 4,
**caractérisé en ce que** la table de la puissance ultrasonique est établie automatiquement dans une phase d'apprentissage, les paramètres de qualité adjoints aux liaisons individuelles étant simplement prédéfinis manuellement additionnellement.

6. Procédé selon la revendication 5,
**caractérisé en ce que** la puissance ultrasonique est calculée à l'aide d'un régulateur lâche en tant que fonction de l'impédance et du gradient de la déformation du fil métallique par les règles paramétrisées à l'aide d'un réseau neuronal dans la phase d'apprentissage.

7. Procédé pour le contrôle de qualité lors de la liaison ultrasonique de fils métalliques, dans lequel la déformation d'un fil métallique à lier sur une surface de contact est surveillée en permanence et une unité de coin de liaison à transducteur et un générateur ultrasonique sont utilisés,
**caractérisé en ce que**, dans une phase d'apprentissage, une table de la puissance ultrasonique représentant respectivement l'état actuel du processus est établie en tant que fonction du gradient de la déformation du fil métallique, de l'impédance de l'unité de coin de liaison à transducteur ainsi que de la déformation du fil métallique actuellement atteinte à l'aide des règles paramétrisées à l'aide d'un réseau neuronal, la puissance ultrasonique nécessaire pour l'état actuel respectif du processus étant calculée à l'aide d'un régulateur lâche et que des niveaux ultrasoniques déterminés par le réseau neuronal sont commutés sur le générateur ultrasonique à un cycle prédéterminé fixement.
